# FASCICULE DE BREVET EUROPEEN

(11) **EP 0 838 901 B1**
(45) Date de publication et mention de la délivrance du brevet: **08.01.2003**
(21) Numéro de dépôt: 97203198.3
(22) Date de dépôt: 14.10.1997
(51) Int. Cl.: H03M 1/06, H04N 5/18, H04N 9/72

(54) **Dispositif de conversion analogique/numérique à dynamique d'entrée régulée**
Analog-Digital-Wandlungsgerät mit geregelter Eingangsdynamik
Analogue to digital conversion device with regulated input dynamic range

(30) Priorité: 25.10.1996 FR 9613068
(43) Date de publication de la demande: 29.04.1998
(73) Titulaire: Koninklijke Philips Electronics N.V., 5621 BA Eindhoven (NL)
(72) Inventeur: Belin, Philippe, 75008 Paris (FR)
(74) Mandataire: Charpail, François

(56) Documents cités:
- EP-A- 0 178 044
- EP-A- 0 341 326
- US-A- 5 371 522
- US-A- 5 371 552

## Description

La présente invention concerne un dispositif de conversion analogique/numérique, présentant une entrée dite analogique destinée à recevoir une tension analogique d'entrée, une entrée dite de référence à laquelle doit être appliquée une tension de référence, et une sortie numérique destinée à délivrer un signal numérique résultant de la conversion de la tension analogique d'entrée, comprenant :
. un amplificateur présentant une première entrée reliée à l'entrée analogique via une capacité dite de liaison, d'une part, et à l'entrée de référence via une résistance dite de liaison, d'autre part, une deuxième entrée reliée à une borne d'alimentation via une capacité de stockage, et une sortie destinée à délivrer un signal résultant de l'amplification de la différence entre des signaux reçus sur les première et deuxième entrées,
. un convertisseur analogique/numérique présentant une entrée analogique reliée à la sortie de l'amplificateur et une sortie constituant la sortie du dispositif,
. un module de régulation comportant une source de courant contrôlable reliée à la capacité de stockage et permettant de faire varier la tension aux bornes de ladite capacité, et un premier comparateur destiné à effectuer une comparaison entre un signal prédéterminé dit de régulation et un signal représentatif du signal de sortie de l'amplificateur, et à délivrer un signal permettant le contrôle de la conduction de la source de courant, le module de régulation étant activé lorsque la tension analogique d'entrée présente un palier dit de référence.

Dans un tel dispositif, l'amplificateur reçoit sur sa première entrée une tension dont la composante continue, appelée composante continue moyenne, équivaut à une moyenne des variations des niveaux de tension des paliers de référence que présente la tension analogique d'entrée. La deuxième entrée de l'amplificateur reçoit la tension présente aux bornes de la capacité de stockage. La différence entre ladite tension et la composante continue moyenne est ajustée de sorte que le signal de sortie de l'amplificateur présente des paliers de référence dont les niveaux de tension sont constants et déterminés par le signal de régulation. En cas de variation de la composante continue moyenne, le module de régulation a pour fonction d'ajuster la valeur de la tension aux bornes de la capacité de stockage de sorte que le niveau de tension des paliers de référence du signal de sortie de l'amplificateur reste inchangé. L'amplitude de variation de la composante continue moyenne peut être importante. Les valeurs instantanées des potentiels des signaux dynamiques qui constituent la composante alternative du signal présent sur la première entrée de l'amplificateur, et qui représentent les informations qui font l'objet de la conversion, ont par conséquent une grande amplitude de variation, qui peut dépasser l'admissibilité de l'amplificateur et conduire à une saturation de celui-ci, provoquant ainsi un écrêtage et donc une perte d'informations. Le document EP 0 341 326 décrit l'état de la technique correspondant au préambule de la revendication 1.

La présente invention a pour but de remédier à cet inconvénient, en proposant un dispositif de conversion analogique/numérique dans lequel le niveau de tension de la composante continue moyenne est soumis à un asservissement.

Selon l'invention, un tel dispositif est caractérisé en ce qu'il comprend en outre un deuxième comparateur inséré entre l'entrée de référence et la résistance de liaison, présentant une première entrée reliée à l'entrée de référence, une deuxième entrée reliée à la capacité de stockage, et une sortie reliée à la résistance de liaison.

Dans ce dispositif de conversion analogique/numérique, la tension aux bornes de la capacité de stockage est égale à la tension de référence en régime permanent, c'est-à-dire lorsque le niveau de tension de la composante continue moyenne et les niveaux de tension des paliers de référence du signal de sortie de l'amplificateur sont constants. La sortie du deuxième comparateur est alors inactive, ce qui signifie qu'elle n'a pas d'effet correcteur sur la composante continue moyenne. Une variation de la composante continue moyenne sera rapidement compensée par le module de régulation qui imposera une variation du même ordre à la tension aux bornes de la capacité de stockage, de manière à ce que la différence entre les deux tensions reste inchangée. La tension aux bornes de la capacité de stockage devenant différente de la tension de référence, la sortie du deuxième comparateur prend un état actif permettant de modifier la valeur de la tension aux bornes de la capacité de liaison, ce qui a pour effet de faire revenir le niveau de tension de la composante continue moyenne vers celui qu'elle avait en régime permanent. La tension aux bornes de la capacité de stockage évolue de manière similaire du fait de l'action du module de régulation, ce qui diminue progressivement l'ampleur de la correction effectuée au moyen du deuxième comparateur. Lorsque le régime permanent est rétabli, la sortie dudit comparateur redevient inactive.

Un mode de réalisation de l'invention permet de générer simplement le signal de régulation à l'intérieur du dispositif. Un dispositif de conversion analogique/numérique conforme à ce mode de réalisation est caratérisé en ce que, le convertisseur analogique/numérique étant muni d'une échelle de résistances soumise à une différence de potentiel donnée, échelle fournissant à chaque noeud intermédiaire entre deux résistances une tension dite d'échantillonnage utilisée par le convertisseur à des fins de comparaison avec un signal reçu sur son entrée analogique, le signal de régulation est élaboré à partir d'au moins une desdites tensions d'échantillonnage.

Les tensions d'échantillonnage permettent ainsi d'attribuer au signal de régulation une valeur prise au sein d'une large gamme établie sur la base de tensions pré-existantes.

Dans une variante de ce mode de réalisation, un dispositif de conversion analogique/numérique est caractérisé en ce que le signal de régulation est l'une des tensions d'échantillonnage.

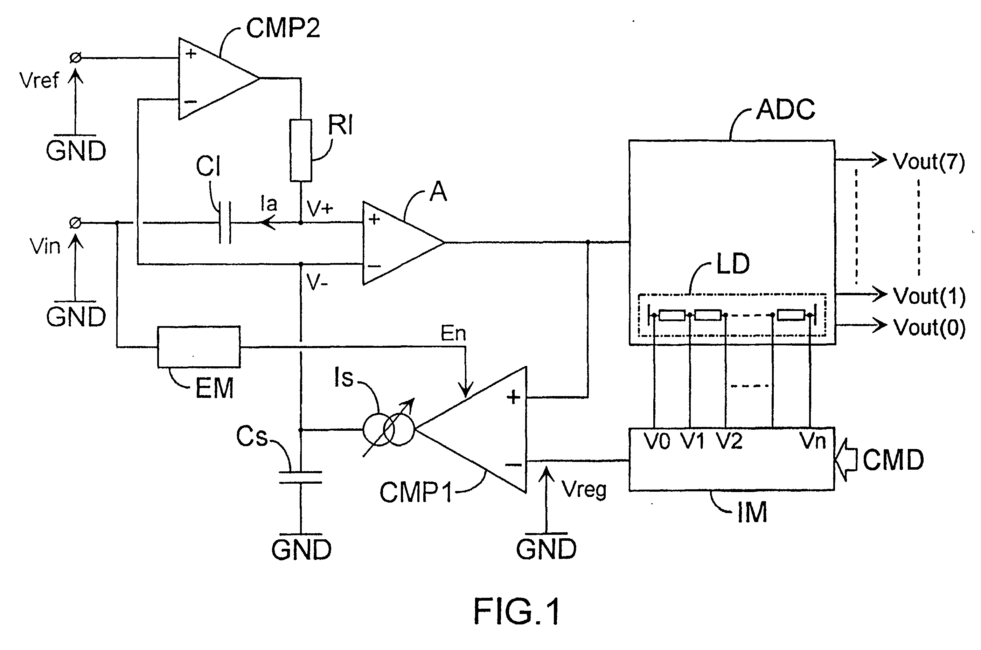

L'invention sera mieux comprise à l'aide de la description suivante, faite à titre d'exemple non-limitatif et en regard de la figure 1 qui représente un schéma fonctionnel partiel décrivant un dispositif de conversion analogique/numérique selon un mode de réalisation avantageux de l'invention.

Ce dispositif présente une entrée dite analogique destinée à recevoir une tension analogique d'entrée Vin, une entrée de référence à laquelle doit être appliquée une tension de référence Vref, et une sortie numérique destinée à délivrer un signal numérique Vout[0:7] résultant de la conversion de la tension analogique d'entrée Vin. Ce dispositif comprend :
. un amplificateur A présentant une première entrée reliée à l'entrée analogique via une capacité de liaison Cl, d'une part, et à l'entrée de référence via une résistance de liaison Rl, d'autre part, une deuxième entrée reliée à une borne d'alimentation GND via une capacité de stockage Cs, et une sortie destinée à délivrer un signal résultant de l'amplification de la différence entre les signaux que reçoit l'amplificateur A sur ses première et deuxième entrées,
. un convertisseur analogique/numérique ADC présentant une entrée analogique reliée à la sortie de l'amplificateur A et une sortie constituant la sortie du dispositif, et délivrant, dans cet exemple, un signal de sortie codé sur 8 bits, Vout[0:7],
. un module de régulation comportant une source de courant contrôlable Is reliée à la capacité de stockage Cs et permettant de faire varier la tension aux bornes de ladite capacité Cs, et un premier comparateur CMP1 effectuant une comparaison entre un signal de régulation Vreg prédéterminé et un signal représentatif du signal de sortie de l'amplificateur, et délivrant un signal permettant le contrôle de la conduction de la source de courant Is.

Dans le mode de réalisation décrit ici, le convertisseur analogique/numérique ADC est muni d'une échelle de résistances LD soumise à une différence de potentiel donnée. Cette échelle LD fournit à chaque noeud intermédiaire entre deux résistances une tension dite d'échantillonnage Vi (pour i=0 à n), utilisée par le convertisseur ADC à des fins de comparaison avec le signal qu'il reçoit sur son entrée analogique. Le signal de régulation Vreg est élaboré à partir de ces tensions d'échantillonnage par un module IM, commandé par un signal CMD, qui peut par exemple provenir d'un registre numérique programmable non représenté sur la figure. En fonction de la nature du signal de régulation Vreg que l'on souhaite obtenir, le module IM peut prendre des formes différentes. Si l'on souhaite que le signal de régulation Vreg soit l'une des tensions d'échantillonnage Vi (pour i=0 à n), le module IM sera constitué d'un multiplexeur à n+1 entrées de données recevant chacune l'une des tensions d'échantillonnage, et à p entrées de sélection avec n+1=2^{p}, le signal de signal de commande CMD étant alors codé sur p bits. Si l'on souhaite obtenir une meilleure définition de la valeur du signal de régulation Vreg, on doit pouvoir attribuer audit signal Vreg une valeur intermédiaire entre deux tensions d'échantillonnage successives, Vi et Vi+1 (pour i=0 à n-1). Ceci peut être réalisé en incorporant au module IM un module d'interpolation composé d'une échelle d'interpolation composée de résistances disposées en série. Les extrémités de cette échelle d'interpolation reçoivent lesdites tensions d'échantillonnage successives, sélectionnées au moyen du signal de commande CMD, dont la structure est alors différente de celle qu'il devrait présenter dans le cas du simple multiplexage exposé ci-dessus. Les noeuds intermédiaires entre deux résistances successives de l'échelle d'échantillonnage fournissent des tensions intermédiaires aux tensions d'échantillonnage, l'une de ces tensions intermédiaires étant sélectionnée au moyen du signal de commande CMD pour constituer le signal de régulation Vreg. De tels modes de réalisation sont à la portée du spécialiste et ne sortent pas du cadre de l'invention.

Dans l'exemple de réalisation représenté sur la figure 1, le comparateur CMP1 est un comparateur analogique qui effectue une comparaison entre le signal de sortie de l'amplificateur A et un signal de régulation Vreg de nature analogique. Dans d'autres modes de réalisation de l'invention, il est possible d'effectuer une comparaison numérique du signal de sortie du convertisseur analogique/numérique ADC avec un signal de régulation numérique, au moyen d'un comparateur de nature numérique, dont la sortie commande par tout-ou-rien la conduction de la source de courant contrôlable IS.

Le module de régulation ne peut agir sur la tension aux bornes de la capacité de stockage Cs que lorsqu'il est activé par un signal d'activation En. Ce signal est généré sur la base du signal d'entrée Vin par un détecteur EM, dont la fonction est d'identifier les paliers de référence que présente le signal d'entrée Vin, et de placer le signal En à un état actif pendant la durée de chacun de ces paliers, et à un état inactif sinon. La structure de ce détecteur EM est connue du spécialiste et n'a pas été explicitée sur la figure.

Le dispositif comprend en outre un deuxième comparateur CMP2 inséré entre l'entrée de référence et la résistance de liaison Rl. Ce comparateur CMP2 présente une première entrée reliée à l'entrée de référence, une deuxième entrée reliée à la capacité de stockage Cs, et une sortie reliée à la résistance de liaison Rl.

Le comparateur CMP2 réalise un asservissement de la composante continue moyenne, dont le mode d'opération peut être décrit comme suit :

En régime permanent, c'est-à-dire lorsque le niveau de tension de la composante continue moyenne, correspondant à la valeur de la composante continue de la tension V+ et les niveaux de tension des paliers de référence du signal de sortie de l'amplificateur A sont constants, la tension V- aux bornes de la capacité de stockage Cs est égale à la tension de référence Vref. La sortie du deuxième comparateur CMP2 est alors inactive, ce qui signifie qu'elle n'a pas d'effet correcteur sur la composante continue de la tension V+. Si, par exemple, le niveau de tension des paliers de référence que présente la tension analogique d'entrée Vin diminue fortement et durablement, la valeur de la composante continue de la tension V+ diminue également. Cette diminution est rapidement compensée par le module de régulation qui imposera une diminution du même ordre à la tension V- aux bornes de la capacité de stockage Cs, de manière à ce que la différence entre les valeurs de la composante continue de la tension V+ et celle de V- reste inchangée. Du fait de la diminution de la valeur de V- par rapport à Vref, la sortie du deuxième comparateur CMP2 prend un état actif provoquant l'injection d'un courant Ia, appelé courant d'appoint, dans la capacité de liaison Cl, permettant ainsi de modifier la valeur de la tension aux bornes de ladite capacité Cl, ce qui a pour effet de faire augmenter la valeur de la composante continue de la tension V+ vers celle qu'elle avait en régime permanent. La tension V- aux bornes de la capacité de stockage Cs évolue de manière similaire du fait de l'action du module de régulation, ce qui diminue progressivement l'ampleur de la correction effectuée au moyen du deuxième comparateur CMP2, la valeur du courant injecté dans la capacité de liaison Cl diminuant progressivement. Lorsque le régime permanent est rétabli, la sortie du comparateur CMP2 redevient inactive. Un tel raisonnement est aisément transposable au cas où la composante continue moyenne subirait une augmentation, le courant d'appoint Ia circulant alors dans le sens opposé à celui indiqué sur la figure lorsque V- devient supérieur à Vref, dans le but de décharger la capacité de liaison Cl et de diminuer ainsi la tension à ses bornes. Les variations de la composante continue moyenne sont donc rapidement corrigées au moyen du système d'asservissement réalisé au moyen du comparateur CMP2, ce qui limite considérablement les risques de perte d'information qui pourraient résulter d'une saturation de l'amplificateur A en l'absence dudit asservissement.

## Revendications

1. Dispositif de conversion analogique/numérique, présentant une entrée dite analogique destinée à recevoir une tension analogique d'entrée (Vin), une entrée dite de référence à laquelle doit être appliquée une tension de référence (Vref), et une sortie numérique (Vout) destinée à délivrer un signal numérique résultant de la conversion de la tension analogique d'entrée, comprenant :
. un amplificateur (A) présentant une première entrée reliée à l'entrée analogique via une capacité dite de liaison (Cl), d'une part, et à l'entrée de référence via une résistance dite de liaison (Rl), d'autre part, une deuxième entrée reliée à une borne d'alimentation via une capacité de stockage (Cs), et une sortie destinée à délivrer un signal résultant de l'amplification de la différence entre des signaux reçus sur les première et deuxième entrées,
. un convertisseur analogique/numérique (ADC) présentant une entrée analogique reliée à la sortie de l'amplificateur et une sortie constituant la sortie du dispositif (Vout),
. un module de régulation comportant une source de courant (Is) contrôlable reliée à la capacité de stockage et permettant de faire varier la tension aux bornes de ladite capacité, et un premier comparateur (CMP1) effectuant une comparaison entre un signal prédéterminé dit de régulation (Vreg) et un signal représentatif du signal de sortie de l'amplificateur, et délivrant un signal permettant le contrôle de la conduction de la source de courant, le module de régulation étant activé lorsque la tension analogique d'entrée présente un palier dit de référence,
dispositif **caractérisé en ce qu'**il comprend en outre un deuxième comparateur (CMP2) inséré entre l'entrée de référence et la résistance de liaison, présentant une première entrée reliée à l'entrée de référence, une deuxième entrée reliée à la capacité de stockage, et une sortie reliée à la résistance de liaison.

2. Dispositif de conversion analogique/numérique selon la revendication 1, **caractérisé en ce que**, le convertisseur analogique/numérique étant muni d'une échelle de résistances (LD) soumise à une différence de potentiel donnée, échelle fournissant à chaque noeud intermédiaire entre deux résistances une tension dite d'échantillonnage (V0.. Vn) utilisée par le convertisseur à des fins de comparaison avec un signal reçu sur son entrée analogique, le signal de régulation est élaborée à partir d'au moins une desdites tensions d'échantillonnage.

3. Dispositif de conversion analogique/numérique selon la revendication 2, **caractérisé en ce que** le signal de régulation est l'une des tensions d'échantillonnage.

## Patentansprüche

1. Analog-Digital-Wandlungsgerät mit einem sogenannten analogen Eingang für den Erhalt einer analogen Eingangsspannung (Vin), einem sogenannten Referenzeingang, an den eine Referenzspannung (Vref) angelegt werden muss, und einem digitalen Ausgang (Vout) zur Abgabe eines digitalen Signals, das aus der Wandlung der analogen Eingangsspannung hervorgeht, bestehend aus:
. einem Verstärker (A) mit einem ersten Eingang, einerseits mit dem analogen Eingang über eine sogenannte Verbindungskapazität (Cl), und andererseits mit dem Referenzeingang über einen sogenannten Verbindungswiderstand (Rl) verbunden, einem zweiten Eingang, über eine Speicherungskapazität (Cs) mit einer Versorgungsklemme verbunden, und einem Ausgang zur Abgabe eines Signals, das aus der Verstärkung der Differenz zwischen den am ersten und zweiten Eingang erhaltenen Signalen hervorgeht,
. einem Analog-Digital-Wandlungsgerät (ADC) mit einem analogen Eingang, mit dem Ausgang des Verstärkers verbunden, und einem den Ausgang des Geräts bildenden Ausgang (Vout),
. einem Steuermodul mit einer regelbaren Stromquelle (Is), mit der Speicherungskapazität verbunden und das es ermöglicht, die Spannung an den Klemmen der besagten Kapazität zu verändern, und einem ersten Vergleicher (CMP1), um einen Vergleich zwischen einem vorbestimmten, sogenannten Regelsignal (Vreg) und einem für das Ausgangssignal des Verstärkers stehenden Signals vorzunehmen, und um ein Signal abzugeben, das die Steuerung der Leitfähigkeit der Stromquelle ermöglicht, wobei das Steuermodul aktiv ist, wenn die analoge Eingangsspannung einer sogenannte Referenzstufen entspricht,
Gerät **dadurch gekennzeichnet, dass** es außerdem einen zweiten, zwischen den Referenzeingang und den Verbindungswiderstand eingefügten Vergleicher (CMP2) aufweist, mit einem ersten, mit dem Referenzeingang verbundenen Eingang, einem zweiten, mit der Speicherungskapazität verbundenen Eingang, und einem mit dem Verbindungswiderstand verbundenen Ausgang.

2. Analog-Digital-Wandlungsgerät nach Anspruch 1, **dadurch gekennzeichnet, dass** das Analog-Digital-Wandlungsgerät mit einer Widerstandsstufe (LD) versehen ist, die einer bestimmten Potentialdifferenz unterliegt, wobei die Stufe an jeden Zwischenknoten zwischen zwei Widerständen eine sogenannte Abtastspannung (VO ...Vn) abgibt, die vom Wandler zu Vergleichszwecken mit einem Signal verwendet wird, das er an seinem analogen Eingang erhält, wobei das Regelsignal anhand mindestens einer der besagten Abtastspannungen erzeugt wird.

3. Analog-Digital-Wandlungsgerät nach Anspruch 2, **dadurch gekennzeichnet, dass** das Regelsignal eine der Abtastspannungen ist.

## Claims

1. An A/D conversion device having an analog input intended to receive an analog input voltage (Vin), a reference input to which a reference voltage (Vref) must be applied, and a digital output (Vout) intended to supply a digital signal resulting from the conversion of the analog input voltage, comprising:
an amplifier (A) having a first input connected to the analog input via a coupling capacitor (Cl) and to the reference input via a coupling resistor (R1), a second input connected to a power supply terminal via a storage capacitor (Cs), and an output intended to supply a signal resulting from the amplification of the difference between the signals received at the first and second inputs,
an A/D converter (ADC) having an analog input connected to the output of the amplifier and an output constituting the output (Vout) of the device,
a regulation module comprising a controllable current source (Is) connected to the storage capacitor and allowing the voltage at the terminals of said capacitor to be varied, and a first comparator (CMP1) performing a comparison between a predetermined regulation signal (Vreg) and a signal which is representative of the output signal of the amplifier, and supplying a signal allowing control of the conduction of the current source, the regulation module being active when the analog input voltage has a reference threshold,
**characterized in that** the device also comprises a second comparator (CMP2) arranged between the reference input and the coupling resistor, which comparator has a first input connected to the reference input, a second input connected to the storage capacitor and an output connected to the coupling resistor.

2. An A/D conversion device as claimed in claim 1, **characterized in that**, the A/D converter being provided with a resistance ladder (LD) which is subject to a given potential difference and supplies, at each junction point between two resistors, a sampling voltage (V0...Vn) used by the converter for performing a comparison with a signal received at its analog input, the regulation signal is processed on the basis of at least one of said sampling voltages.

3. An A/D conversion device as claimed in claim 2, **characterized in that** the regulation signal is one of the sampling voltages.
